(19) Europäisches Patentamt
European Patent Office
Office européen des brevets

(11) **EP 4 628 941 A1**

(12) **EUROPEAN PATENT APPLICATION**
published in accordance with Art. 153(4) EPC

(43) Date of publication:
**08.10.2025   Bulletin 2025/41**

(21) Application number: 23903582.7

(22) Date of filing: **15.12.2023**

(51) International Patent Classification (IPC):
**G01T 1/17** (2006.01)     **G01T 1/36** (2006.01)

(52) Cooperative Patent Classification (CPC):
**G01T 1/17; G01T 1/36**

(86) International application number:
**PCT/JP2023/044958**

(87) International publication number:
**WO 2024/128301 (20.06.2024 Gazette 2024/25)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:   **15.12.2022   JP 2022200569**

(71) Applicant: HORIBA, Ltd.
**Minami-ku
Kyoto-shi
Kyoto 601-8510 (JP)**

(72) Inventors:
• **MURATA, Shunsuke
  Kyoto-shi, Kyoto 601-8510 (JP)**
• **VALIEV, Ildar
  Kyoto-shi, Kyoto 601-8510 (JP)**

(74) Representative: **Isarpatent
Patent- und Rechtsanwälte
Barth Hassa Peckmann & Partner mbB
Friedrichstraße 31
80801 München (DE)**

(54) **SIGNAL PROCESSING METHOD, SIGNAL PROCESSING DEVICE, RADIATION DETECTING DEVICE, AND COMPUTER PROGRAM**

(57)    Provided are a signal processing method, a signal processing device, a radiation detection apparatus, and a computer program for stably obtaining an accurate radiation spectrum.

The signal processing method includes calculating a slope of a non-response line, which is a part other than a step wave, included in a signal including the step wave generated in response to detection of radiation, measuring a wave height of the step wave, and correcting the wave height according to the slope.

FIG.4

EP 4 628 941 A1

## Description

Technical Field

The present invention relates to a signal processing method, a signal processing device, a radiation detection apparatus, and a computer program for processing a signal generated by detection of radiation.

Background Art

A radiation detection apparatus that detects radiation such as X-rays includes a radiation detector and a signal processing device that processes a signal output by the radiation detector. The radiation detector has a radiation detection element such as a semiconductor radiation detection element, and a voltage is applied to the radiation detection element. When radiation is incident on the radiation detection element, electric charges are generated inside the radiation detection element, and the generated electric charges move inside the radiation detection element and are collected by the voltage. The radiation detector outputs a signal including a response wave having a wave height corresponding to the quantity of collected electric charges. The response wave is a signal wave generated in response to incidence and detection of radiation. The response wave is, for example, a step wave whose signal value rises in a one-step shape when radiation is detected. The wave height of the step wave corresponds to energy of the radiation. The radiation detection apparatus counts step waves for each type of energy and generates a spectrum representing a relationship between energy of radiation and the counted number. In this way, the radiation detection apparatus detects radiation.

Parameters related to the wave height of the step wave output by the radiation detector change according to a temperature of a component included in the radiation detector. For example, capacitance of the component changes according to the temperature. When the temperature of the component included in the radiation detector changes, the wave height of the step wave corresponding to the quantity of collected electric charges changes, energy of radiation corresponding to the wave height changes, and accurate energy of the detected radiation cannot be obtained. For this reason, it is impossible to obtain an accurate radiation spectrum. Conventionally, by adjusting a temperature of the radiation detection element to a constant value, radiation has been detected without causing energy of radiation to change. Patent Literature 1 discloses technology for obtaining an accurate radiation spectrum by measuring a temperature using a temperature sensor and adjusting an energy measurement method according to the temperature, and technology for obtaining an accurate radiation spectrum by correcting a wave height according to a time width of a step wave that depends on the temperature.

Citation List

Patent Literature:

Patent Literature 1: Japanese Patent Application Laid-Open No. 2015-25740 Summary

Technical Problems

The technology for adjusting the temperature of the radiation detection element requires a mechanism for adjusting the temperature, which increases the size of the radiation detector and the cost. The technology for measuring the temperature can only measure a temperature at a position of the temperature sensor, and cannot reliably measure a temperature that truly affects the wave height of the step wave, making it difficult to obtain an accurate radiation spectrum. The technology for correcting the wave height according to the time width of the step wave estimates the temperature from each step wave, and thus errors increase, making it difficult to stably obtain an accurate radiation spectrum.

The invention has been made in consideration of the above circumstances, and an object of the invention is to provide a signal processing method, a signal processing device, a radiation detection apparatus, and a computer program for stably obtaining an accurate radiation spectrum.

Solution to Problems

A signal processing method according to one aspect of the present invention, is characterized by comprising: calculating a slope of a non-response line, which is a part other than a step wave, included in a signal including the step wave generated in response to detection of radiation; measuring a wave height of the step wave; and correcting the wave height according to the slope.

In an aspect of the invention, the slope of the non-response line, which is the part other than the step wave, included in the signal including the step wave generated in response to detection of radiation is calculated, and the wave height of the step wave is corrected according to the slope of the non-response line. Since the slope of the non-response line reflects the temperature that affects the wave height of the step wave, the wave height can be accurately corrected according to the temperature by performing correction according to the slope of the non-response line. When compared to using a feature of each step wave, by using a feature of a signal in a period having a time length longer than a time width of the step wave, correction errors are decreased, and it becomes possible to stably acquire accurate radiation energy corresponding to the wave height of the step wave.

The signal processing method according one aspect of the present invention is characterized by further comprising: calculating a center line of the non-response line by smoothing the non-response line including noise; and calculating a slope of the center line as the slope of the non-response line.

In an aspect of the invention, by smoothing the non-response line of the signal, the center line of the non-response line of the signal is calculated, and the slope of the center line is calculated. By using the center line of the non-response line as the slope of the non-response line, the slope of the non-response line of the signal can be easily obtained.

The signal processing method according one aspect of the present invention is characterized by further comprising: calculating an instantaneous slope of the non-response line at a time point when a signal value included in the non-response line is obtained; and calculating a moving average of the instantaneous slope as the slope of the non-response line.

In an aspect of the invention, the instantaneous slope of the non-response line is calculated, and the moving average of the instantaneous slope is calculated. The moving average of the instantaneous slope is used as the slope of the non-response line. In this way, by correcting the wave height of the step wave using a feature of the signal over a longer period of time, it becomes possible to more stably acquire accurate radiation energy.

A signal processing method according one aspect of the present invention is characterized by comprising: calculating a noise level included in a signal including a step wave generated in response to detection of radiation; measuring a wave height of the step wave; and correcting the wave height according to the noise level.

In an aspect of the invention, the noise level included in the signal including the step wave generated in response to detection of radiation is calculated, and the wave height of the step wave is corrected according to the noise level. Since the noise level reflects the temperature that affects the wave height of the step wave, the wave height can be accurately corrected according to the temperature by performing correction according to the noise level. When compared to using a feature of each step wave, by using a feature of a signal in a period having a time length longer than a time width of the step wave, correction errors are decreased, and it becomes possible to stably acquire accurate radiation energy corresponding to the wave height of the step wave.

The signal processing method according one aspect of the present invention is characterized by further comprising: using a first signal value, a second signal value, and a third signal value in a time series included in a non-response line, which is a part other than the step wave, included in the signal to calculate a difference value between a difference between the first signal value and the second signal value and a difference between the second signal value and the third signal value; and calculating a moving average of the difference value as the noise level.

In an aspect of the invention, the difference value between the difference between the first signal value and the second signal value included in the non-response line and the difference between the second signal value and the third signal value included in the non-response line is calculated, and the moving average of the calculated difference value is calculated. The moving average of the difference value between the differences is used as the noise level. The noise level can be easily obtained, and the wave height of the step wave is corrected using a feature of the signal over a longer period of time.

The signal processing method according one aspect of the present invention is characterized by further comprising: smoothing a non-response line, which is a part other than the step wave, included in the signal to calculate a center line of the non-response line; calculating a square of a difference between the center line and a signal value included in the non-response line; and calculating a moving average of the square of the difference as the noise level.

In an aspect of the invention, the square of the difference between the center line of the non-response line of the signal and the signal value is calculated, and the moving average of the square of the difference is calculated. The moving average of the square of the difference is used as the noise level. The noise level can be easily obtained, and the wave height of the step wave is corrected using a feature of the signal over a longer period of time.

A signal processing device according one aspect of the present invention is characterized by comprising: a slope calculation unit configured to calculate a slope of a non-response line, which is a part other than a step wave, included in a signal including the step wave generated in response to detection of radiation; a wave height measurement unit configured to measure a wave height of the step wave; a correction unit configured to correct the wave height according to the slope; and a counting unit configured to count the step wave for each corrected wave height.

A signal processing device according one aspect of the present invention is characterized by comprising: a noise calculation unit configured to calculate a noise level included in a signal including a step wave generated in response to detection of radiation; a wave height measurement unit configured to measure a wave height of the step wave; a correction unit configured to correct the wave height according to the noise level; and a counting unit configured to count the step wave for each corrected wave height.

In an aspect of the invention, the signal processing device calculates the noise level or the slope of the non-response line of the signal generated in response to detection of radiation, and corrects the wave height of the step wave according to the noise level or the slope of the non-response line. When compared to using the feature of each step wave, using the feature of the signal in a period having a time length longer than the time width of the step wave reduces correction errors. Therefore, the signal processing device can stably acquire accurate radiation energy corresponding to the wave height of the step wave.

A radiation detection apparatus according one aspect of the present invention is characterized by comprising: a radiation detector configured to generate a step wave in response to incidence of radiation and output a signal including the step wave; a slope calculation unit configured to calculate a slope of a non-response line which is included in the signal and is a part other than the step wave; a wave height measurement unit configured to measure a wave height of the step wave; a correction unit configured to correct the wave height according to the slope; a counting unit configured to count the step wave for each corrected wave height; and a spectrum generation unit configured to generate a spectrum of the radiation based on a number counted by the counting unit.

A radiation detection apparatus according one aspect of the present invention is characterized by comprising: a radiation detector configured to generate a step wave in response to incidence of radiation and output a signal including the step wave; a noise calculation unit configured to calculate a noise level included in the signal; a wave height measurement unit configured to measure a wave height of the step wave; a correction unit configured to correct the wave height according to the noise level; a counting unit configured to count the step wave for each corrected wave height; and a spectrum generation unit configured to generate a spectrum of the radiation based on a number counted by the counting unit.

In an aspect of the invention, the radiation detection apparatus calculates the noise level or the slope of the non-response line of the signal including the step wave generated in response to detection of radiation, and corrects the wave height of the step wave according to the noise level or the slope of the non-response line. In addition, the radiation detection apparatus generates a spectrum of radiation using the corrected wave height. When compared to using the feature of each step wave, using the feature of the signal in a period having a time length longer than the time width of the step wave reduces correction errors. Therefore, the radiation detection apparatus can stably acquire accurate radiation energy and stably acquire an accurate radiation spectrum.

A computer program according one aspect of the present invention is characterized by causing a computer to execute processing of: calculating a slope of a non-response line, which is a part other than a step wave, included in a signal including the step wave generated in response to detection of radiation; and correcting a wave height of the step wave according to the slope.

A computer program according one aspect of the present invention is characterized by causing a computer to execute processing of: calculating a noise level included in a signal including a step wave generated in response to detection of radiation; and correcting a wave height of the step wave according to the noise level.

In an aspect of the invention, the slope of the noise level or the non-response line of the signal including the step wave generated in response to detection of radiation is calculated, and the wave height of the step wave is corrected according to the noise level or the slope of the non-response line. When compared to using the feature of each step wave, using the feature of the signal in a period having a time length longer than the time width of the step wave reduces correction errors, and accurate radiation energy corresponding to the wave height of the step wave is stably acquired.

Advantageous Effects of Invention

The invention has an excellent effect such as making it possible to stably obtain an accurate radiation spectrum.

Brief Description of Drawings

FIG. 1 is a block diagram illustrating a functional configuration example of a radiation detection apparatus.
FIG. 2 is a schematic cross-sectional view illustrating an example of a radiation detection element.
FIG. 3 is a schematic cross-sectional view illustrating a configuration example of a radiation detector.
FIG. 4 is a block diagram illustrating a functional configuration of the radiation detector and a signal processing unit according to Embodiment 1.
FIG. 5 is a schematic graph illustrating an example of a signal including a step wave.
FIG. 6 is a schematic graph illustrating a relationship between a temperature and a slope of a non-response line of a signal output by the radiation detector.
FIG. 7 is a flowchart illustrating an example of a procedure of processing performed by the signal processing unit according to Embodiment 1.
FIG. 8 is a graph illustrating examples of a first period and a second period.
FIG. 9 is a flowchart illustrating a procedure of a first example of processing performed by a signal processing unit according to Embodiment 2.
FIG. 10 is a flowchart illustrating a procedure of a second example of processing performed by the signal processing unit according to Embodiment 2.
FIG. 11 is a block diagram illustrating a functional configuration of an information processing unit according to Embodiment 3.
FIG. 12 is a block diagram illustrating a functional configuration of the radiation detector and a signal processing unit according to Embodiment 4.

FIG. 13 is a block diagram illustrating an internal configuration example of an analysis unit.

Description of Embodiments

Hereinafter, the invention will be described in detail with reference to the drawings illustrating embodiments thereof.

<Embodiment 1>

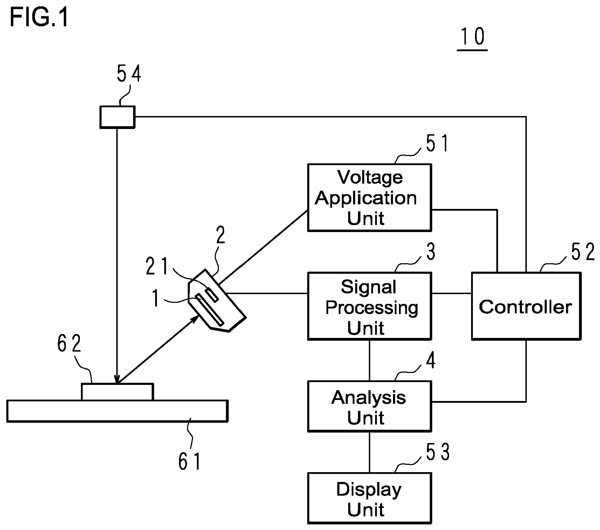

FIG. 1 is a block diagram illustrating a functional configuration example of a radiation detection apparatus 10. The radiation detection apparatus 10 is, for example, an X-ray fluorescence analysis apparatus. The radiation detection apparatus 10 includes a radiation unit 54 that radiates radiation such as an electron beam or X-rays onto a sample 62, a sample stage 61 on which the sample 62 is placed, and a radiation detector 2. Radiation is radiated from the radiation unit 54 onto the sample 62, radiation such as fluorescent X-rays is generated in the sample 62, and the radiation detector 2 detects radiation generated from the sample 62. In the figure, radiation is indicated by arrows. Note that the radiation detection apparatus 10 may be configured to hold the sample 62 using a method other than a method of placing the sample on the sample stage 61.

The radiation detector 2 includes a radiation detection element 1 and a preamplifier 21. A signal processing unit 3 and a voltage application unit 51 that applies a voltage required for radiation detection to the radiation detection element 1 are connected to the radiation detector 2. The signal processing unit 3 corresponds to a signal processing device. An analysis unit 4 is connected to the signal processing unit 3. A display unit 53 such as a liquid crystal display or an EL display (Electroluminescent Display) is connected to the analysis unit 4. The signal processing unit 3, the analysis unit 4, the voltage application unit 51, and the radiation unit 54 are connected to the controller 52. The controller 52 controls operations of the signal processing unit 3, the analysis unit 4, the voltage application unit 51, and the radiation unit 54. For example, the controller 52 is configured using a computer having a calculation unit and a memory. The controller 52 may be configured to receive an operation of a user and control each unit of the radiation detection apparatus 10 in response to the received operation.

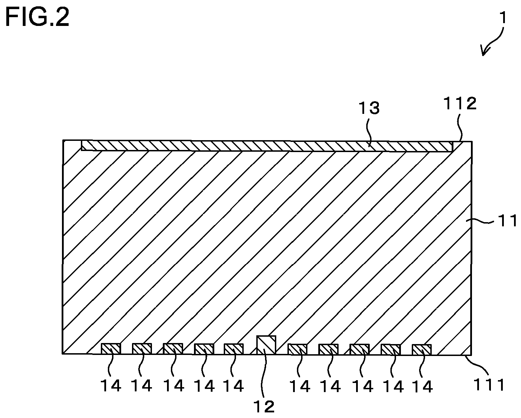

FIG. 2 is a schematic cross-sectional view illustrating an example of the radiation detection element 1. The radiation detection element 1 is a silicon drift type radiation detection element. The radiation detection element 1 has a flat plate shape on the whole. The radiation detection element 1 includes a disc-shaped semiconductor portion 11 made of Si (silicon). A component of the semiconductor portion 11 is n-type Si. The semiconductor portion 11 has an incident surface 112 located on an incident side where radiation to be detected is incident, and an electrode surface 111 located on a back side of the incident surface 112.

A signal output electrode 12, which is an electrode that outputs a signal when radiation is detected, is provided at a center of the electrode surface 111. A component of the signal output electrode 12 is Si, which is the same type as that of the semiconductor portion 11. For example, the component of the signal output electrode 12 is n+Si in which a specific dopant such as phosphorus is doped into Si. In addition, a plurality of curved electrodes 14 having a multi-ring shape is provided on the electrode surface 111. A component of the curved electrodes 14 is a semiconductor of a different type from that of the semiconductor portion 11, and is p-type Si in which a specific dopant such as boron is doped into Si. For example, the component of the curved electrodes 14 is p+Si. The plurality of curved electrodes 14 surrounds the signal output electrode 12, and distances between the signal output electrode 12 and the respective curved electrodes 14 are different from each other. Even though FIG. 2 illustrates five curved electrodes 14, more curved electrodes 14 may be provided. A shape of each of the curved electrodes 14 may be a modified circular ring shape.

A counter electrode 13, which is an electrode to which a voltage is applied, is formed on the incident surface 112. The counter electrode 13 is doped with a dopant that makes Si a different type of semiconductor from the component of the semiconductor portion 11. A component of the counter electrode 13 is P-type Si in which a specific dopant such as boron is doped into Si, and is, for example, p+Si. The counter electrode 13 is formed on most of a region of the incident surface 112, including a center of the incident surface 112.

The plurality of curved electrodes 14 is connected to the voltage application unit 51. The voltage application unit 51 applies a voltage to the curved electrodes 14 so that an innermost curved electrode 14 has the highest potential and an outermost curved electrode 14 has the lowest potential. In addition, the radiation detection element 1 is configured such that predetermined electrical resistance is generated between adjacent curved electrodes 14 at different distances from the signal output electrode 12. For example, an electrical resistance channel to which two curved electrodes 14 are connected is formed by adjusting a component of a portion located between adjacent curved electrodes 14. That is, the plurality of curved electrodes 14 is connected in a daisy chain through electrical resistance. When a voltage is applied from the voltage application unit 51, potentials of the curved electrodes 14 increase in sequence from a curved electrode 14 furthest from the signal output electrode 12 to a curved electrode 14 closest to the signal output electrode 12. Note that the plurality of curved electrodes 14 may include a pair of adjacent curved electrodes 14 having the same potential.

Due to the potentials of the plurality of curved electrodes 14, an electric field (potential gradient) is generated inside the semiconductor portion 11 such that the potentials increase stepwise as a distance from the signal output electrode 12 decreases and decrease stepwise as the distance from the signal output electrode 12 increases. In addition, the counter electrode 13 is connected to the voltage application unit 51. The voltage application unit 51 applies a voltage to the counter electrode 13 such that a potential of the counter electrode 13 becomes a potential between a potential of the innermost curved electrode 14 and a potential of the outermost curved electrode 14. In this way, an electric field is generated inside the semiconductor portion 11 such that a potential increases as a distance from the signal output electrode 12 decreases.

Radiation such as X-rays, photons in general (including UV and visible light), electron beams, or other charged particle beams is incident on the radiation detection element 1. The radiation is incident mainly from a side of the incident surface 112 into the semiconductor portion 11. Electric charges, the quantity of which corresponds to energy of radiation absorbed in the semiconductor portion 11, is generated in the semiconductor portion 11. The generated electric charges are electrons and holes. The generated electric charges move due to the electric field inside the semiconductor portion 11, and one type of electric charges is concentrated and flows into the signal output electrode 12. In this embodiment, electrons generated by incidence of radiation move and flow into the signal output electrode 12. In this way, the signal output electrode 12 collects electrons generated inside the semiconductor portion 11 by radiation incident on the semiconductor portion 11. A current signal corresponding to the quantity of electric charges of electrons flowing into the signal output electrode 12 is output from the signal output electrode 12.

The preamplifier 21 is connected to the signal output electrode 12. A signal output by the signal output electrode 12 is input to the preamplifier 21. The preamplifier 21 converts a current signal into a voltage signal and outputs the voltage signal. The preamplifier 21 outputs a signal according to the quantity of electric charges of the electrons collected by the signal output electrode 12. Since electrons, the quantity of which corresponds to energy of radiation, are generated, and the signal output electrode 12 collects the generated electrons, the preamplifier 21 outputs a signal according to the energy of the radiation. Note that a part of the preamplifier 21 may be included inside the radiation detector 2, and the other part may be disposed outside the radiation detector 2.

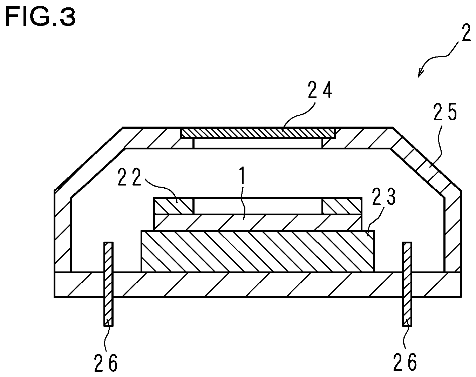

FIG. 3 is a schematic cross-sectional view illustrating a configuration example of the radiation detector 2. The radiation detector 2 is an SDD (Silicon Drift Detector). The radiation detector 2 includes a housing 25 in a shape of a cylinder with a truncated cone connected to one end. The housing 25 is formed by covering a plate-shaped bottom plate with a cap-shaped cover. A window 24 made of a window material that transmits radiation is provided at a tip of the housing 25. A collimator 22, the radiation detection element 1, and a substrate 23 are disposed inside the housing 25. The radiation detector 2 does not include a temperature adjustment unit such as a Peltier element for adjusting a temperature inside the radiation detector 2, and a temperature sensor for measuring the temperature.

The radiation detection element 1 is mounted on a surface of the substrate 23, and is disposed at a position facing the window 24. The radiation detection element 1 is disposed so that the electrode surface 111 faces the substrate 23, and the incident surface 112 faces the window 24. The collimator 22 has a cylindrical shape with both ends open, and is made of a material that blocks radiation. The collimator 22 is disposed between the radiation detection element 1 and the window 24. Radiation mainly passes through the window 24 and enters the inside of the housing 25, and the collimator 22 blocks a part of the radiation. The radiation detection element 1 detects incident radiation that is not blocked by the collimator 22.

Wiring is formed on the substrate 23, and the preamplifier 21 is mounted thereon. The preamplifier 21 is omitted in FIG. 3. A back surface of the substrate 23 is in thermal contact with a bottom plate of the housing 25 directly or via an intermediate material. Heat from the radiation detection element 1 is conducted to the bottom plate of the housing 25 through the substrate 23, and is released from the bottom plate to the outside of the radiation detector 2.

The radiation detector 2 has a plurality of lead pins 26 penetrating the bottom plate of the housing 25. The lead pins 26 are connected to the substrate 23 using a method such as wire bonding. Application of a voltage to the radiation detection element 1 by the voltage application unit 51 and output of a signal from the preamplifier 21 are performed through the lead pins 26. Note that the radiation detector 2 may not have the window 24 made of the window material, and may have a configuration in which a part of the housing 25 corresponding to the window 24 is open. The radiation detector 2 may not have the collimator 22. Alternatively, the radiation detector 2 may have a configuration not including the housing 25. The radiation detector 2 may further include other components.

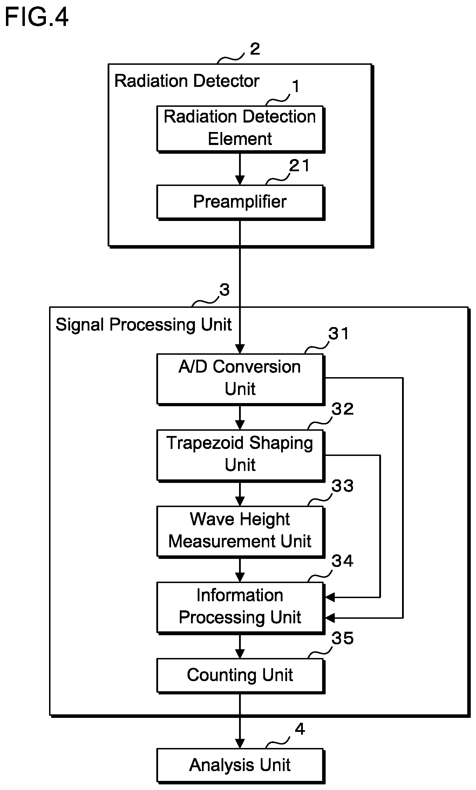

FIG. 4 is a block diagram illustrating a functional configuration of the radiation detector 2 and the signal processing unit 3 according to Embodiment 1. In FIG. 4, a flow of a signal is indicated by arrows. The radiation detection element 1 collects electrons, the quantity of which corresponds to energy of incident radiation, at the signal output electrode 12, and outputs a current signal corresponding to the quantity of electric charges of the collected electrons from the signal output electrode 12. The preamplifier 21 converts the current signal output by the radiation detection element 1 into a voltage signal, and generates a response wave in response to detection of radiation. In this embodiment, the response wave is a step wave whose signal value rises in a one-step shape when radiation is detected. The radiation detector 2 outputs a signal including the step wave generated by the preamplifier 21.

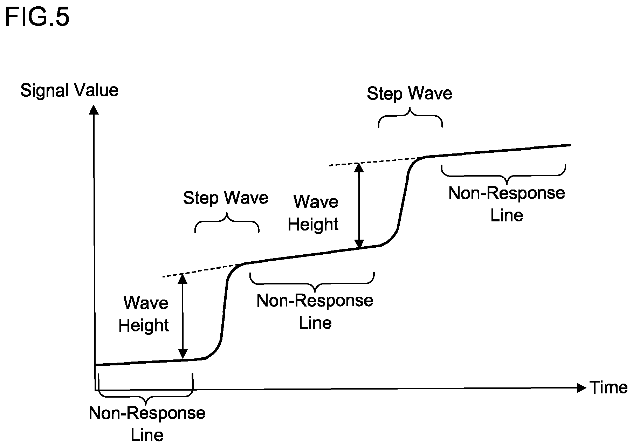

FIG. 5 is a schematic graph illustrating an example of a signal including a step wave. In the figure, a horizontal axis represents time, and a vertical axis represents signal value. Each time radiation is incident on the radiation detection element 1 and an event in which the radiation detection element 1 detects radiation occurs once, the radiation detector 2 outputs a step wave whose signal value rises in a one-step shape. In response to one event, one step wave whose signal value rises in a one-step shape is generated. When a plurality of events occurs, a signal including a plurality of step waves is output. Each time an event occurs, a signal value rises. A height of a step whose signal value rises is set to a wave height of a step wave. The wave height of the step wave corresponds to the quantity of electric charges of the electrons collected by the signal output electrode 12 due to one event, and corresponds to energy of incident radiation. The radiation detection apparatus 10 determines energy of radiation according to the wave height of the step wave.

A signal output by the radiation detector 2 is input to the signal processing unit 3. The signal processing unit 3 executes a signal processing method. As illustrated in FIG. 4, the signal processing unit 3 includes an A/D (analog/digital) conversion unit 31. The A/D conversion unit 31 receives input of a signal including a step wave from the radiation detector 2 and A/D converts the signal including the step wave. The A/D conversion unit 31 receives input of a continuous signal, samples the signal at predetermined time intervals, and A/D converts values obtained by sampling to generate discrete signal values. The A/D conversion unit 31 generates an A/D converted signal by sequentially generating signal values at the predetermined time intervals. The A/D converted signal includes a plurality of discrete signal values.

A trapezoid shaping unit 32 is connected to the A/D conversion unit 31. A signal is input to the trapezoid shaping unit 32 from the A/D conversion unit 31. A conversion unit that converts a signal so as to cancel out waveform distortion caused by a signal delay, and a noise removal unit that removes noise from the signal may be connected between the A/D conversion unit 31 and the trapezoid shaping unit 32.

The trapezoid shaping unit 32 is configured using a trapezoid shaping filter. The trapezoid shaping unit 32 shapes a waveform of an input signal using the trapezoid shaping filter, thereby converting a step-shaped step wave included in the signal into a trapezoid wave. A height from a predetermined signal reference to a maximum value of the trapezoid wave is set as a wave height of a trapezoid wave. The wave height of the trapezoid wave converted from the step wave corresponds to the wave height of the step wave. A wave height measurement unit 33 is connected to the trapezoid shaping unit 32. The wave height measurement unit 33 receives input of a signal from the trapezoid shaping unit 32, and measures a wave height of a trapezoid wave included in the signal, thereby measuring the wave height of the step wave.

An information processing unit 34 is connected to the A/D conversion unit 31, the trapezoid shaping unit 32, and the wave height measurement unit 33. The information processing unit 34 is configured using an element that performs calculation. For example, the information processing unit 34 is configured using an FPGA (field-programmable gate array). The information processing unit 34 receives input of a signal including a step wave from the A/D conversion unit 31, and receives input of a wave height from the wave height measurement unit 33. The information processing unit 34 performs a process of correcting the wave height input from the wave height measurement unit 33 according to a feature of a signal input from the A/D conversion unit 31.

The wave height of the step wave measured by the wave height measurement unit 33 is affected by temperature. Parameters related to the wave height of the step wave output by the radiation detector 2 change according to temperatures of components such as the radiation detection element 1 and the preamplifier 21 included in the radiation detection element 1. For example, capacitance of the component changes according to temperature. As a result of change in parameter, the wave height of the step wave output from the radiation detector 2 according to the quantity of electric charges of the electrons collected by the signal output electrode 12 of the radiation detection element 1 changes. For this reason, the wave height of the step wave changes according to the temperature inside the radiation detector 2. Since energy of radiation incident on the radiation detection element 1 is specified according to the wave height of the step wave, an effect of temperature makes it difficult to obtain accurate energy of radiation.

The information processing unit 34 performs a process of correcting the wave height of the step wave so as to remove an effect of temperature. In the radiation detection element 1, even in a state where no radiation is incident, a dark current flows, and a current signal continues to be output from the signal output electrode 12. A signal value output by the radiation detector 2 increases according to the current signal output from the signal output electrode 12. For this reason, as illustrated in FIG. 5, the signal value increases over time in a part other than the step wave included in a signal output by the radiation detector 2.

A part other than the step wave included in the signal output by radiation detector 2 is referred to as a non-response line. The non-response line is a part of the signal not responding to detection of radiation. The non-response line is divided by the step wave. The non-response line includes noise and is in a straight line shape. A difference in signal value between non-response lines before and after a step wave corresponds to the wave height of the step wave. Since the signal output by the radiation detector 2 increases over time, the non-response lines are inclined. A slope of a non-response line is change in signal value per unit time, and is a value obtained by dividing the amount of change in the signal value of the non-response line by a length of elapsed time.

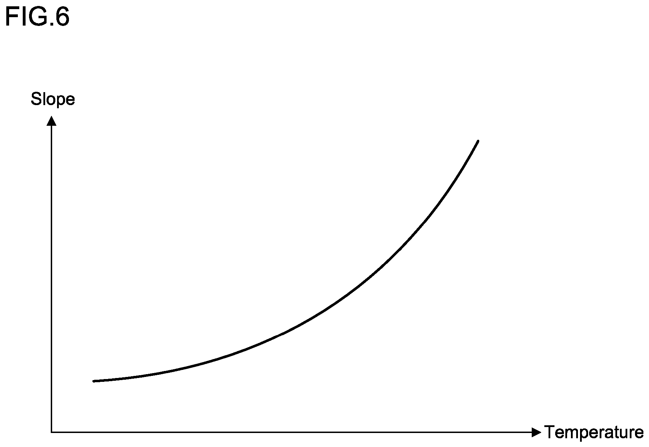

The dark current flowing through the radiation detection element 1 is affected by the temperature of the radiation detection element 1. For this reason, the slope of the non-response line of the signal output by the radiation detector 2 is affected by the temperature inside the radiation detector 2. FIG. 6 is a schematic graph illustrating a relationship between the temperature and the slope of the non-response line of the signal output by the radiation detector 2. In the figure, a horizontal axis represents the temperature of the radiation detection element 1, and a vertical axis represents the slope of the non-response line of the signal output by the radiation detector 2. As the temperature increases, the dark current flowing through the radiation detection element 1 increases, the current signal output from the signal output electrode 12 increases, and a rate of increase of the signal output by the radiation detector 2 increases. For this reason, as illustrated in FIG. 6, as the temperature increases, the slope of the non-response line increases. As such, since there is a correlation between the slope of the non-response line and the temperature, it is possible to estimate the temperature according to the slope of the non-response line.

As described above, the wave height of the step wave changes depending on the temperature inside the radiation detector 2. A relationship between the wave height of the step wave and the temperature is experimentally or theoretically specified. When the temperature is confirmed, the wave height of the step wave can be corrected to remove an effect of the temperature from the relationship between the wave height of the step wave and the temperature. Therefore, the temperature can be estimated depending on the slope of the non-response line, and the wave height of the step wave can be corrected depending on the estimated temperature. For example, the wave height of the step wave can be corrected by converting the wave height of the step wave to a wave height obtained at a predetermined temperature. In this manner, the information processing unit 34 corrects the wave height of the step wave.

For example, the information processing unit 34 stores a table or a function representing the relationship between the slope of the non-response line and temperature, and specifies the temperature from the slope of the non-response line using the table or the function. For example, the information processing unit 34 stores a table or a function representing a relationship between the measured wave height of the step wave, a corrected wave height, and the temperature, and specifies the corrected wave height from the specified temperature using the table or the function. For example, the information processing unit 34 stores a table or a function representing a relationship between the temperature and a conversion coefficient for converting the measured wave height into the corrected wave height, specifies the conversion coefficient from the temperature using the table or the function, and calculates the corrected wave height using the conversion coefficient. The conversion coefficient may include a plurality of coefficients. For example, the conversion coefficient includes a shift coefficient that indicates the amount of change in the wave height, and a gain coefficient that indicates the magnification of the change in the wave height.

The information processing unit 34 may be configured to correct the wave height of the step wave according to the slope of the non-response line without taking the temperature into account. For example, the information processing unit 34 stores a table or a function representing a relationship between the measured wave height of the step wave, the corrected wave height, and the slope of the non-response line, and specifies the corrected wave height from the slope of the non-response line using the table or the function. For example, the information processing unit 34 stores a table or a function representing a relationship between the slope of the non-response line and the conversion coefficient, specifies the conversion coefficient from the slope of the non-response line using the table or the function, and calculates the corrected wave height using the conversion coefficient.

Alternatively, the information processing unit 34 may be configured to correct the wave height of the step wave according to both the slope of the non-response line and the temperature. For example, the information processing unit 34 stores a table or a function representing a relationship between the measured wave height of the step wave, the corrected wave height, the slope of the non-response line, and the temperature, and specifies the corrected wave height from the slope of the non-response line and the specified temperature using the table or the function. For example, the information processing unit 34 stores a table or a function representing a relationship between the slope of the non-response line, the temperature, and the conversion coefficient, specifies the conversion coefficient from the slope of the non-response line and the temperature using the table or the function, and calculates the corrected wave height using the conversion coefficient.

A counting unit 35 is connected to the information processing unit 34. The information processing unit 34 inputs the corrected wave height of the step wave to the counting unit 35. The counting unit 35 counts step waves for each wave height. For example, the counting unit 35 is a multi-channel analyzer. The counting unit 35 may be configured to count step waves for all wave heights, or may be configured to count step waves only for a specific wave height. The information processing unit 34 may input an instruction to the counting unit 35 to count +1 for the corrected wave height, and the counting unit 35 may count for the corrected wave height according to the input instruction. In this way, step waves are counted for each corrected wave height.

The signal processing unit 3 outputs data representing a relationship between the wave height of the step wave and the counted number counted by the counting unit 35. The counted number corresponds to the number of times that the radiation detector 2 detects radiation having energy corresponding to the corrected wave height of the step wave. The analysis unit 4 receives data output by the signal processing unit 3. The analysis unit 4 is configured using a computer having a calculation unit and a memory. The analysis unit 4 and the controller 52 may be configured by the same computer.

The analysis unit 4 performs a process of generating a spectrum of radiation detected by the radiation detector 2 from a relationship between the wave height of the step wave and the counted number. The analysis unit 4 corresponds to a spectrum generation unit. The spectrum represents a relationship between energy of radiation corresponding to the wave height and the counted number. The analysis unit 4 may further perform a further process such as element analysis of the sample 62 based on the generated spectrum of the radiation. For example, the radiation detector 2 detects fluorescent X-rays, and the analysis unit 4 performs qualitative analysis or quantitative analysis of an element contained in the sample 62 based on a spectrum of the fluorescent X-rays. The display unit 53 displays the spectrum generated by the analysis unit 4 and an analysis result by the analysis unit 4.

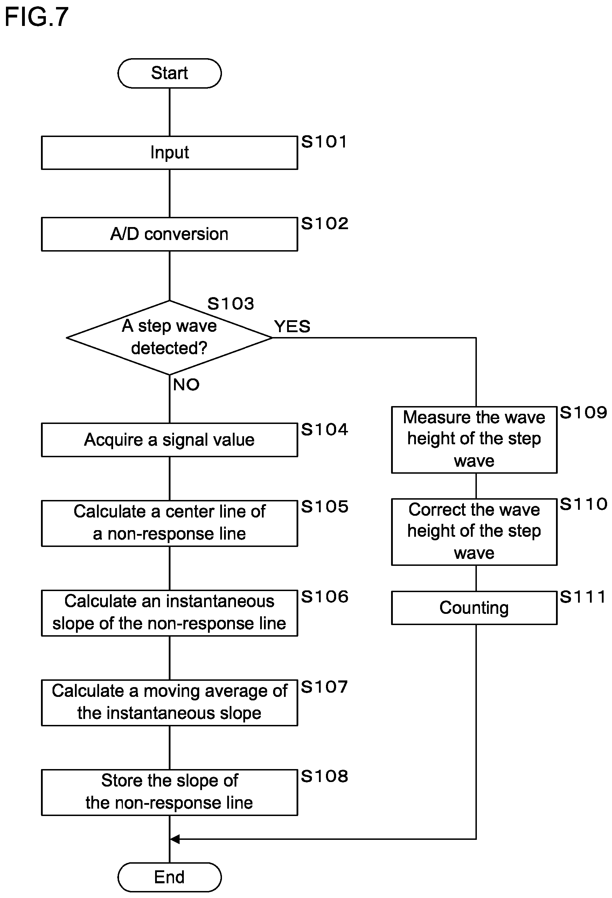

A description will be given of a flow of processing executed by the radiation detection apparatus 10. FIG. 7 is a flowchart illustrating an example of a procedure of processing executed by the signal processing unit 3 according to Embodiment 1. Hereinafter, step is abbreviated as S. When radiation is incident on the radiation detection element 1, the radiation detector 2 generates a step wave having a wave height according to energy of radiation, and outputs a signal including the step wave. In addition, the radiation detector 2 outputs a signal even in a state in which radiation is not incident on the radiation detection element 1. The signal processing unit 3 receives input of a signal from the radiation detector 2 (S101). The A/D conversion unit 31 performs A/D conversion on the input signal (S102). The A/D converted signal includes a plurality of discrete signal values. The A/D conversion unit 31 inputs the A/D converted signal to the trapezoid shaping unit 32 and the information processing unit 34.

Detection of a step wave is performed on the input signal (S103). The trapezoid shaping unit 32 includes a trapezoid shaping filter having a relatively short time constant and a trapezoid shaping filter having a longer time constant. In S103, the trapezoid shaping unit 32 converts a waveform of the input signal into a trapezoidal wave by the trapezoid shaping filter having the short time constant. The trapezoid shaping unit 32 measures a wave height of the trapezoidal wave, determines that a step wave has been detected when the wave height of the trapezoidal wave is a predetermined threshold or more, and determines that a step wave has not been detected when the wave height of the trapezoidal wave is less than the predetermined threshold. Note that the trapezoid shaping unit 32 may determine that a step wave has been detected when the wave height of the trapezoidal wave exceeds the threshold, and may determine that a step wave has not been detected when the wave height of the trapezoidal wave is the threshold or less. Processing of S103 targets a latest part of a signal. For example, the latest part of the signal is a part within a latest period having a predetermined time length in the signal, or a part including a predetermined number of latest signal values in the signal.

When a step wave has not been detected (S103: NO), the trapezoid shaping unit 32 inputs information indicating that a step wave has not been detected to the information processing unit 34, and the information processing unit 34 acquires a signal value (S104). In S104, the information processing unit 34 acquires a signal value of the latest part of the signal input from the A/D conversion unit 31. The information processing unit 34 then calculates a center line of a non-response line of the signal (S105). Processing of S105 also targets the latest part of the signal. When a step wave has not been detected, a processing target part of the signal input from the A/D conversion unit 31 does not include a step wave and is a non-response line. In S105, the information processing unit 34 smooths the latest part of the signal to calculate the center line of the non-response line and acquires a value on the center line at this time point. For example, the information processing unit 34 performs smoothing using a smoothing filter.

The information processing unit 34 then calculates an instantaneous slope of the non-response line (S106). In S106, the information processing unit 34 calculates an instantaneous slope of a center line as the slope of the non-response line. For example, the information processing unit 34 calculates a slope of the center line calculated in S105. For example, the information processing unit 34 calculates the instantaneous slope of the center line using a value on the center line acquired in S105 and a value on the center line acquired in S105 included in a cycle of immediately previously executed processing.

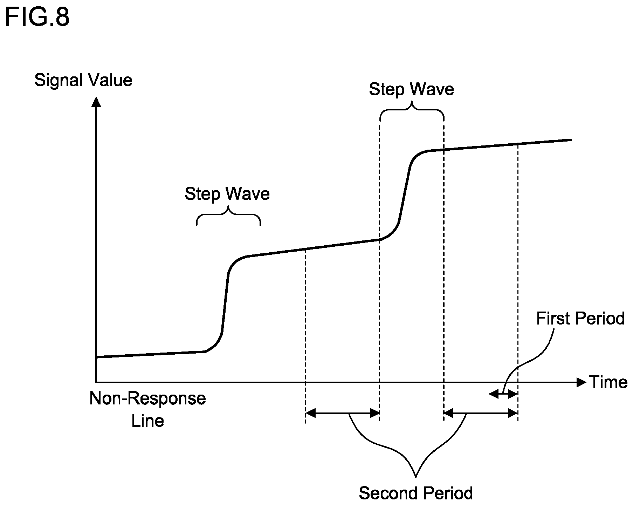

The information processing unit 34 then calculates a moving average of the instantaneous slope of the non-response line (S107). In S107, for example, the information processing unit 34 calculates a simple moving average. A period in which the latest part of the signal used to calculate the instantaneous slope of the center line is obtained is set to a first period, and a period for which the moving average is calculated is set to a second period. FIG. 8 is a graph illustrating examples of the first period and the second period. The first period is a period having a predetermined time length in the signal. The second period is a period having a predetermined time length longer than the time length of the first period and longer than a time width of the step wave. The second period includes a current first period and includes a plurality of past first periods. The second period is a period during which the signal includes a non-response line, and a period in which the signal includes a step wave is not included in the second period. As illustrated in FIG. 8, the second period may include a plurality of periods divided by a period in which the signal includes a step wave. The second period moves over time.

The information processing unit 34 calculates a simple moving average of the instantaneous slope of the non-response line by averaging a plurality of instantaneous slopes obtained for a plurality of first periods included in the second period. The plurality of instantaneous slopes includes the instantaneous slope of the non-response line calculated in S106 and an instantaneous slope of a non-response line calculated for each of the plurality of past first periods. The simple moving average of the instantaneous slope of the non-response line is a feature of a signal in the second period having a time length longer than the time width of the step wave.

In S107, the information processing unit 34 may calculate a moving average other than the simple moving average. For example, the information processing unit 34 calculates a weighted moving average of the instantaneous slope of the non-response line. The information processing unit 34 calculates the weighted moving average of the instantaneous slope of the non-response line by multiplying the instantaneous slope obtained for each first period included in the second period by a weight and then calculating the average. Weights for the respective first periods are different from each other. A weight for the current first period is the largest, and weights for the past first periods increase as a distance from the current one decreases. Weight values are stored in advance in the information processing unit 34. The weighted moving average of the instantaneous slope of the non-response line is a feature of a signal in the second period having a time length longer than the time width of the step wave, an effect of a more recent signal is greater, and an effect of a more past signal is smaller. For this reason, a feature that strongly represents a most recent signal state while reflecting a past signal state is obtained.

For example, the information processing unit 34 calculates an exponential moving average of the instantaneous slope of the non-response line. The instantaneous slope of the non-response line obtained in S106 is set as slope G(t) at time point t. The exponential moving average of the instantaneous slope of the non-response line at time point t is set as AG(t). An exponential moving average of the instantaneous slope of the non-response line at time point t-1 obtained in a cycle of immediately previously executed processing is set as AG(t-1). The information processing unit 34 calculates the exponential moving average AG(t) of the instantaneous slope of the non-response line using the following Equation (1).

$$AG(t) = aG(t) + (1-a)AG(t-1) \dots (1)$$

A coefficient a included in Equation (1) is a real number greater than zero and less than 1. For example, a = 0.1. The coefficient a is stored in advance in the information processing unit 34. The exponential moving average AG(t) reflects all of past and present states of the non-response line. A period affecting the exponential moving average AG(t) may have a time length longer than the second period. That is, the exponential moving average AG(t) is a feature of the entire signal excluding the step wave. In the exponential moving average AG(t), a weight for the current first period is the largest, and weights for the past first periods increase as a distance from the current one decreases. For this reason, the exponential moving average of the instantaneous slope of the non-response line is a feature amount strongly representing the most recent signal state while reflecting the overall state of the signal excluding the step wave. The information processing unit 34 may calculate other moving averages. In this way, the information processing unit 34 calculates the moving average of the instantaneous slope of the non-response line as the slope of the non-response line in S104 to S107. Processing of S104 to S107 corresponds to a slope calculation unit.

The information processing unit 34 then stores the slope of the non-response line (S108). In S108, the information processing unit 34 stores the moving average of the instantaneous slope of the non-response line as the slope of the non-response line. In addition, the information processing unit 34 stores the signal value acquired in S104. When a simple moving average or a weighted moving average is used as the moving average, the information processing unit 34 further stores the instantaneous slope of the non-response line calculated in S106. After S108 is completed, the signal processing unit 3 ends the processing.

In processing of S104 to S108, the slope of the center line is calculated as the slope of the non-response line. However, the information processing unit 34 may calculate the slope of the non-response line using a method other than a method of calculating the slope of the center line. For example, without performing processing of S105, the information processing unit 34 may calculate the instantaneous slope of the non-response line in S106 based on the signal value acquired in S104 and the signal value acquired in S104 included in the cycle of immediately previously executed processing. That is, the information processing unit 34 may calculate the instantaneous slope of the non-response line by dividing the amount of change in the two obtained signal values by a length of time elapsed between time points at which the two signal values are obtained. Alternatively, the information processing unit 34 may differentiate the signal and determine a value obtained by differentiating the non-response line or a moving average of the value obtained by differentiating the non-response line as the slope of the non-response line.

When a step wave is detected (S103: YES), the wave height of the step wave is measured (S109). In S109, the trapezoid shaping unit 32 converts a waveform of an input signal into a trapezoidal wave using a trapezoid shaping filter having a longer time constant than that of the trapezoid shaping filter used in S103, and inputs the trapezoidal wave to the wave height measurement unit 33. The wave height measurement unit 33 measures the wave height of the step wave by measuring a wave height of the trapezoidal wave. Processing of S109 targets a latest part of the signal. The wave height measurement unit 33 inputs the measured wave height to the information processing unit 34.

The information processing unit 34 corrects the wave height of the step wave according to the slope of the non-response line of the signal (S110). In S110, the information processing unit 34 uses the moving average of the instantaneous slope of the non-response line calculated in S107 as the slope of the non-response line. The information processing unit 34 reads the stored slope of the non-response line and corrects the wave height of the step wave according to the slope of the non-response line.

As described above, for example, the information processing unit 34 uses a table or a function representing a relationship between the slope of the non-response line and the temperature to specify the temperature from the slope of the non-response line, and uses a table or a function representing a relationship between the wave height of the step wave, the corrected wave height, and the temperature to specify the corrected wave height from the specified temperature. For example, the information processing unit 34 specifies a conversion coefficient from the specified temperature, and calculates the corrected wave height using the conversion coefficient. For example, the information processing unit 34 uses a table or a function representing a relationship between the wave height of the step wave, the corrected wave height, and the slope of the non-response line to specify the corrected wave height from the slope of the non-response line. For example, the information processing unit 34 specifies a conversion coefficient from the slope of the non-response line, and calculates the corrected wave height using the conversion coefficient. For example, the information processing unit 34 uses a table or a function representing a relationship between the wave height of the step wave, the corrected wave height, the slope of the non-response line, and the temperature to specify the corrected wave height from the slope of the non-response line and the specified temperature. For example, the information processing unit 34 specifies a conversion coefficient from the slope of the non-response line and the temperature, and calculates the corrected wave height using the conversion coefficient. In this way, the information processing unit 34 performs a process of correcting the wave height of the step wave so as to remove an effect of the temperature. Processing of S109 corresponds to a correction unit.

The information processing unit 34 then inputs the corrected wave height of the step wave to the counting unit 35. The counting unit 35 performs counting for the corrected wave height of the step wave (S111). In S111, the counting unit 35 increments the counted number by 1 for the input wave height. Note that the information processing unit 34 may input an instruction to perform counting for the corrected wave height of the step wave to the counting unit 35, and the counting unit 35 may perform counting according to the instruction. After S111 is completed, the signal processing unit 3 ends the processing.

The signal processing unit 3 repeatedly executes processing of S101 to S111. Since the wave height of the step wave is corrected to remove the effect of the temperature, energy of radiation corresponding to the wave height is accurately specified without being affected by the temperature. The signal processing unit 3 outputs data representing a relationship between the corrected wave height of the step wave and the counted number counted by the counting unit 35. The analysis unit 4 receives the data output by the signal processing unit 3. Based on the received data, the analysis unit 4 generates a spectrum of radiation detected by the radiation detector 2. The analysis unit 4 displays the spectrum of the radiation on the display unit 53. Since a relationship between the counted number and energy of radiation accurately specified without being affected by the temperature is obtained, an accurate spectrum of the radiation not affected by the temperature is obtained.

In this embodiment, the signal processing unit 3 does not correct the wave height of the step wave by estimating the temperature from each step wave, but corrects the waveform of the step wave according to the slope of the non-response line of the input signal. Since the slope of the non-response line reflects the temperature that truly affects the wave height of the step wave, this embodiment makes it possible to correct the wave height more accurately than technology that corrects the wave height using the temperature sensor. For this reason, accurate radiation energy can be obtained, and an accurate radiation spectrum can be obtained.

Furthermore, the slope of the non-response line of the signal is a feature of the signal in a period having a time length longer than the time width of the step wave. Correction errors are decreased by using the feature of the signal in a period longer than the time width of the step wave when compared to using a feature of each step wave. For this reason, it becomes possible to stably acquire accurate energy of radiation corresponding to the corrected wave height of the step wave. Therefore, it becomes possible to stably acquire an accurate radiation spectrum. By correcting the wave height of the step wave according to the average slope of the non-response lines of the signal within a plurality of periods, it becomes possible to more stably acquire accurate radiation energy and acquire an accurate radiation spectrum.

In this embodiment, it is possible to acquire an accurate radiation spectrum without using a temperature adjustment unit such as a Peltier element that adjusts the temperature inside the radiation detector 2. By not using the temperature adjustment unit, it is possible to reduce the size of the radiation detector 2, and the cost of the radiation detection apparatus 10 is reduced.

<Embodiment 2>

A configuration of a radiation detection apparatus 10 according to the embodiment 2 is similar to that of Embodiment 1. In Embodiment 2, an information processing unit 34 corrects the wave height of the step wave according to a level of noise contained in a signal input from a radiation detector 2 to a signal processing unit 3 so as to remove the effect of the temperature.

A current signal output from a signal output electrode 12 contains noise, and the noise level increases as the temperature increases. For this reason, the level of noise contained in the signal output by the radiation detector 2 increases as the temperature increases. Since there is a correlation between the noise level and the temperature, it is possible to estimate the temperature according to the noise level. Therefore, it is possible to estimate the temperature according to the noise level, and correct the wave height of the step wave according to the estimated temperature. For example, the wave height of the step wave can be corrected by converting the wave height of the step wave into a wave height obtained at a predetermined temperature.

For example, the information processing unit 34 stores a table or a function representing a relationship between the noise level and the temperature, uses the table or the function to specify the temperature from the noise level, and corrects the wave height of the step wave based on the temperature. The information processing unit 34 may be configured to correct the wave height of the step wave according to the noise level without taking the temperature into account. For example, the information processing unit 34 stores a table or a function representing a relationship between the measured wave height of the step wave, the corrected wave height, and the noise level, and specifies the corrected wave height from the noise level using the table or the function. For example, the information processing unit 34 stores a table or a function representing a relationship between the noise level and the conversion coefficient, specifies a conversion coefficient from the noise level using the table or the function, and calculates the corrected wave height using the conversion coefficient.

Alternatively, the information processing unit 34 may be configured to correct the wave height of the step wave according to both the noise level and the temperature. For example, the information processing unit 34 stores a table or a function representing a relationship between the measured wave height of the step wave, the corrected wave height, the noise level, and the temperature, and specifies the corrected wave height from the noise level and the specified temperature using the table or the function. For example, the information processing unit 34 stores a table or a function representing a relationship between the noise level, the temperature, and the conversion coefficient, specifies the conversion coefficient from the noise level and the temperature using the table or the function, and calculates the corrected wave height using the conversion coefficient.

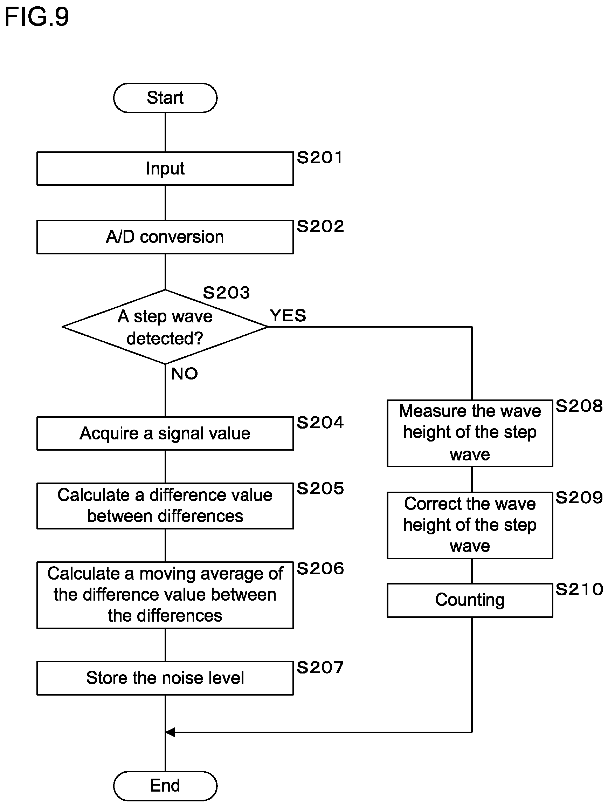

FIG. 9 is a flowchart illustrating a procedure of a first example of processing performed by the signal processing unit 3 according to Embodiment 2. The signal processing unit 3 receives input of a signal from the radiation detector 2 (S201), and an A/D conversion unit 31 A/D converts the input signal (S202). The A/D conversion unit 31 inputs the A/D converted signal to a trapezoid shaping unit 32. Detection of the step wave is performed on the input signal (S203). In S203, similarly to Embodiment 1, the trapezoid shaping unit 32 converts a waveform of the signal into a trapezoidal wave using a trapezoid shaping filter having a short time constant, measures the wave height of the trapezoidal wave, and determines that a step wave has been detected or determines that a step wave has not been detected based on the measured wave height. Processing of S203 targets the latest part of the signal.

When a step wave has not been detected (S203: NO), the trapezoid shaping unit 32 inputs information indicating that a step wave has not been detected to the information processing unit 34, and the information processing unit 34 acquires a signal value (S204). In S204, the information processing unit 34 acquires the signal value of the latest part of the signal input from the A/D conversion unit 31. The information processing unit 34 then calculates a difference value between a difference between the acquired signal value and a signal value acquired in a cycle of immediately previously executed processing and an immediately previous difference (S205).

The acquired most recent signal value is defined as a first signal value $v(t)$, and a signal value acquired in S204 included in the cycle of immediately previously executed processing is defined as a second signal value $v(t-1)$. In addition, a signal value acquired in S204 included in a cycle of second immediately previously executed processing is defined as a third signal value $v(t-2)$. The first signal value, the second signal value, and the third signal value are a plurality of signal values in a time series included in the non-response line, and are signal values at time points $t$, $t-1$, and $t-2$, respectively. In S205, the information processing unit 34 calculates a difference value $\{v(t) - v(t-1)\} - \{v(t-1) - v(t-2)\}$ between a difference $v(t) - v(t-1)$ between the first signal value and the second signal value and a difference $v(t-1) - v(t-2)$ between the second signal value and the third signal value. The calculated difference value between the differences corresponds to an instantaneous noise level.

The information processing unit 34 calculates a moving average of the difference value between the differences (S206). In S206, the information processing unit 34 calculates a simple moving average or a weighted moving average. Alternatively, the information processing unit 34 may calculate an exponential moving average. The difference value between the difference between the first signal value and the second signal value and the difference between the second signal value and the third signal value calculated in S205 is defined as a difference value N(t) between differences at time point t. An exponential moving average of the difference value between the differences at time point t is defined as AN(t). An exponential moving average of the difference value between the differences at time point t-1 obtained in the cycle of immediately previously executed processing is defined as AN(t-1). The information processing unit 34 calculates the exponential moving average AN(t) of the difference value between the difference between the first signal value and the second signal value and the difference between the second signal value and the third signal value using the following Equation (2).

$$AN(t) = bN(t) + (1-b)AN(t-1) \dots (2)$$

A coefficient b included in Equation (2) is a real number greater than zero and less than 1. For example, b = 0.1. The coefficient b is stored in advance in the information processing unit 34. The exponential moving average AN(t) reflects all past and current states of the non-response line. The information processing unit 34 may calculate other moving averages. In this way, in S204 to S206, the information processing unit 34 calculates, as a noise level, a moving average of the difference value between the difference between the first signal value and the second signal value and the difference between the second signal value and the third signal value. Processing of S204 to S206 corresponds to a noise calculation unit.

The information processing unit 34 then stores the noise level (S207). In S207, the information processing unit 34 stores, as the noise level, the moving average of the difference value between the difference between the first signal value and the second signal value and the difference between the second signal value and the third signal value. In addition, the information processing unit 34 stores the signal value acquired in S204. When a simple moving average or a weighted moving average is used as the moving average, the information processing unit 34 further stores the difference value between the differences calculated in S205. After S207 is completed, the signal processing unit 3 ends the processing.

When a step wave is detected (S203: YES), the wave height of the step wave is measured (S208). In S208, similarly to Embodiment 1, the trapezoid shaping unit 32 converts the waveform of the input signal into a trapezoidal wave using a trapezoid shaping filter having a long time constant, and inputs the trapezoidal wave to a wave height measurement unit 33. The wave height measurement unit 33 measures the wave height of the step wave by measuring the wave height of the trapezoidal wave. Processing of S208 targets the latest part of the signal. The wave height measurement unit 33 inputs the measured wave height to the information processing unit 34.

The information processing unit 34 corrects the wave height of the step wave according to the noise level of the signal (S209). In S209, the information processing unit 34 uses, as the noise level, the moving average of the difference value between the difference between the first signal value and the second signal value and the difference between the second signal value and the third signal value calculated in S206. The information processing unit 34 reads the stored noise level and corrects the wave height of the step wave according to the noise level.

For example, the information processing unit 34 uses a table or a function representing a relationship between the noise level and the temperature to specify the temperature from the noise level, and uses a table or a function representing a relationship between the wave height of the step wave, the corrected wave height, and the temperature to specify the corrected wave height from the specified temperature. For example, the information processing unit 34 specifies a conversion coefficient from the specified temperature, and calculates the corrected wave height using the conversion coefficient. For example, the information processing unit 34 uses a table or a function representing a relationship between the wave height of the step wave, the corrected wave height, and the noise level to specify the corrected wave height from the noise level. For example, the information processing unit 34 specifies the conversion coefficient from the noise level and calculates the corrected wave height using the conversion coefficient. For example, the information processing unit 34 uses a table or a function representing a relationship between the wave height of the step wave, the corrected wave height, the noise level, and the temperature to specify the corrected wave height from the noise level and the specified temperature. For example, the information processing unit 34 specifies the conversion coefficient from the noise level and the temperature, and calculates the corrected wave height using the conversion coefficient. In this way, the information processing unit 34 performs a process of correcting the wave height of the step wave so as to remove an effect of the temperature. Processing of S209 corresponds to the correction unit.

The information processing unit 34 then inputs the corrected wave height of the step wave to a counting unit 35. The counting unit 35 performs counting for the corrected wave height of the step wave (S210). After S210 is completed, the signal processing unit 3 ends the processing.

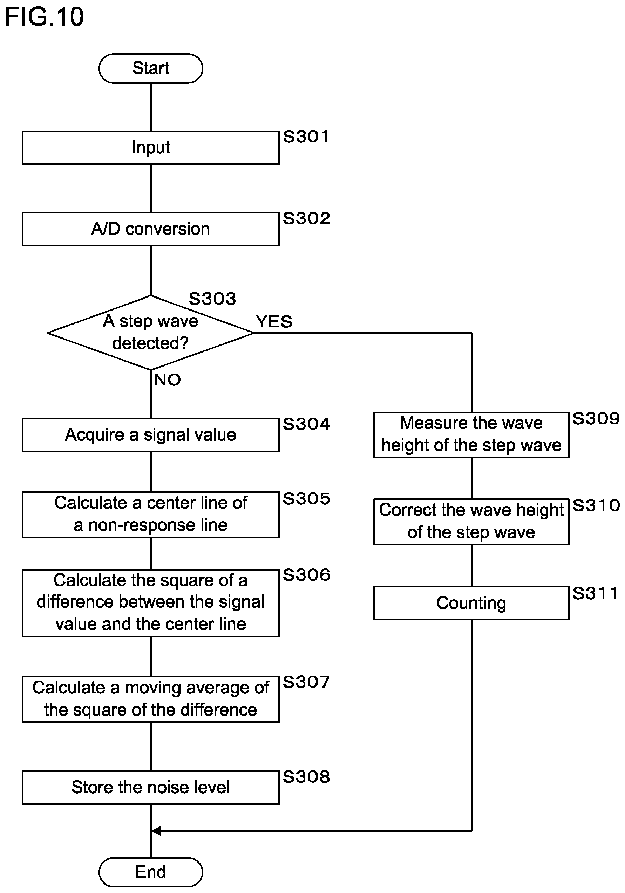

FIG. 10 is a flowchart illustrating a procedure of a second example of processing performed by the signal processing unit 3 according to Embodiment 2. The signal processing unit 3 receives input of a signal from the radiation detector 2 (S301), and the A/D conversion unit 31 A/D converts the input signal (S302). The A/D conversion unit 31 inputs the A/D converted signal to the trapezoid shaping unit 32 and the information processing unit 34. Detection of a step wave is performed on the input signal (S303). In S303, similarly to processing of S203, the trapezoid shaping unit 32 determines that a step wave has been detected or determines that a step wave has not been detected.

When a step wave has not been detected (S303: NO), the trapezoid shaping unit 32 inputs information indicating that a step wave has not been detected to the information processing unit 34, and the information processing unit 34 acquires a signal value (S304). In S304, the information processing unit 34 acquires a signal value of a latest part of the signal input from the A/D conversion unit 31. The information processing unit 34 then calculates a center line of a non-response line of the signal (S305). When the wave height of the step wave has not been measured, a processing target part of the signal input from the A/D conversion unit 31 is a non-response line. In S305, the information processing unit 34 calculates the center line of the non-response line by smoothing the latest part of the signal, and acquires a value on the center line at this time point.

The information processing unit 34 then calculates the square of a difference between the most recent signal value and the center line of the non-response line (S306). The acquired most recent signal value is denoted as v(t) and the value on the center line is denoted as c(t). In S306, the information processing unit 34 calculates the square of the difference $\{v(t) - c(t)\}^2$. The absolute value of the difference between the signal value and the center line of the non-response line corresponds to half the amplitude of noise. For this reason, the square of the difference corresponds to an instantaneous noise level.

The information processing unit 34 then calculates a moving average of the square of the difference between the signal value and the center line of the non-response line (S307). In S307, the information processing unit 34 calculates a simple moving average or a weighted moving average. Alternatively, the information processing unit 34 may calculate an exponential moving average. The square of the difference between the signal value and the center line of the non-response line calculated in S306 is defined as the square of the difference N(t) at time point t. The exponential moving average of the square of the difference at time point t is defined as AN(t), and the exponential moving average of the square of the difference at time point t-1 obtained in the cycle of immediately previously executed processing is defined as AN(t-1). The information processing unit 34 calculates the exponential moving average AN(t) of the square of the difference between the signal value and the center line of the non-response line using the above-mentioned Equation (2). The information processing unit 34 may calculate other moving averages. In this way, the information processing unit 34 calculates the moving average of the square of the difference between the signal value and the center line of the non-response line as the noise level in S304 to S307. Processing of S304 to S307 corresponds to the noise calculation unit.

The information processing unit 34 then stores the noise level (S308). In S308, the information processing unit 34 stores the moving average of the square of the difference between the signal value and the center line of the non-response line as the noise level. In addition, the information processing unit 34 stores the signal value acquired in S304. When a simple moving average or a weighted moving average is used as the moving average, the information processing unit 34 further stores the square of the difference calculated in S306. After S308 is completed, the signal processing unit 3 ends the processing.

When a step wave is detected (S303: YES), the wave height of the step wave is measured (S309). In S309, the wave height is measured similarly to processing of S208. The wave height measurement unit 33 inputs the measured wave height to the information processing unit 34. The information processing unit 34 corrects the wave height of the step wave according to the noise level of the signal (S310). In S310, the information processing unit 34 uses the moving average of the square of the difference between the signal value and the center line of the non-response line calculated in S307 as the noise level. The information processing unit 34 reads the stored noise level and corrects the wave height of the step wave according to the noise level similarly to processing of S209. Processing of S310 corresponds to the correction unit.

The information processing unit 34 then inputs the corrected wave height of the step wave to the counting unit 35. The counting unit 35 performs counting for the corrected wave height of the step wave (S311). After S311 is completed, the signal processing unit 3 ends the processing.

The signal processing unit 3 repeatedly executes processing of S201 to S210 or S301 to S311. The signal processing unit 3 outputs data indicating a relationship between the corrected wave height of the step wave and the counted number counted by the counting unit 35. The analysis unit 4 receives input of the data output by the signal processing unit 3 and generates a spectrum of radiation detected by the radiation detector 2. The analysis unit 4 displays the spectrum of the radiation on the display unit 53. Similarly to Embodiment 1, energy of radiation corresponding to the wave height is accurately specified without being affected by the temperature, and an accurate radiation spectrum not affected by the temperature can be obtained.

In Embodiment 2, the waveform of the step wave is corrected according to the noise level of the signal including the step wave. Since the noise level reflects the temperature that truly affects the wave height of the step wave, Embodiment 2 also makes it possible to correct the wave height more accurately when compared to technology that corrects the wave height using the temperature sensor. For this reason, accurate radiation energy can be obtained and an accurate radiation spectrum can be obtained.

In addition, the noise level of the signal is a feature of the signal in a period having a time length longer than the time width of the step wave. Correction errors are decreased by using the feature of the signal in the period having the time length longer than the time width of the step wave when compared to using a feature of each step wave. For this reason, it is possible to stably acquire accurate radiation energy corresponding to the corrected wave height of the step wave, and it is possible to stably acquire an accurate radiation spectrum. By correcting the wave height of the step wave according to an average noise level of the signal within a plurality of periods, it is possible to more stably acquire accurate radiation energy and acquire an accurate radiation spectrum.

In Embodiment 2, it is possible to acquire an accurate radiation spectrum without using the temperature adjustment unit. By not using the temperature adjustment unit, it is possible to reduce the size of the radiation detector 2, and the cost of the radiation detection apparatus 10 is reduced.

<Embodiment 3>

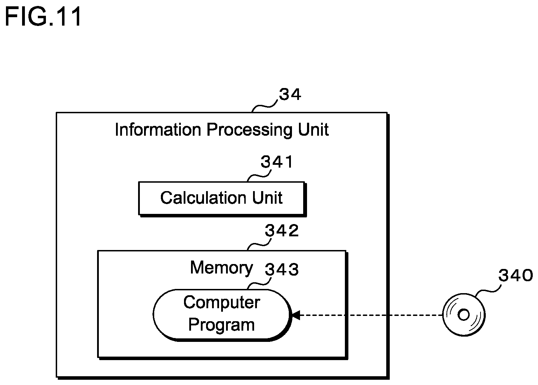

In Embodiment 3, an information processing unit 34 executes processing using a computer program. FIG. 11 is a block diagram illustrating a functional configuration of the information processing unit 34 according to Embodiment 3. The information processing unit 34 has a calculation unit 341 and a memory 342. The calculation unit 341 is configured using, for example, a CPU (Central Processing Unit), a GPU (Graphics Processing Unit), or a multi-core CPU. The calculation unit 341 may be configured using a quantum computer. The memory 342 is a nonvolatile memory. The memory 342 stores a computer program 343. The computer program 343 is stored in the memory 342 using a recording device (not illustrated) by being read from a recording medium 340, such as an optical disc or a portable memory, that stores the computer program 343 and written to the memory 342. The calculation unit 341 executes processing required for the information processing unit 34 in accordance with the computer program 343. The computer program 343 may be a computer program product. The memory 342 may store data required for processing.

The calculation unit 341 executes information processing according to the computer program 343, thereby executing processing required for the information processing unit 34 in Embodiment 1 or 2. In this way, the information processing unit 34 is realized. A configuration and a function of a part of a radiation detection apparatus 10 other than a signal processing unit 3 are the same as those of Embodiment 1 or 2. A configuration and a function of a part of the signal processing unit 3 other than the information processing unit 34 are the same as those of Embodiment 1 or 2. The signal processing unit 3 and the radiation detection apparatus 10 execute the same processing as that of Embodiment 1 or 2.

In Embodiment 3 as well, the signal processing unit 3 repeatedly executes processing of S101 to S111, S201 to S210, or S301 to S311. The signal processing unit 3 outputs data indicating a relationship between the corrected wave height of the step wave and the counted number counted by a counting unit 35. An analysis unit 4 receives input of the data output by the signal processing unit 3 and generates a spectrum of radiation detected by a radiation detector 2. The analysis unit 4 causes the display unit 53 to display the spectrum of the radiation. Similarly to Embodiment 1 or 2, energy of radiation corresponding to the wave height is accurately specified without being affected by the temperature, and an accurate spectrum of the radiation not affected by the temperature can be obtained.

In Embodiment 3, similarly to Embodiment 1 or 2, when compared to technology of correcting the wave height using the temperature sensor, it is possible to more accurately correct the wave height, accurate radiation energy is obtained, and an accurate radiation spectrum is obtained. Similarly, correction errors are reduced, and it is possible to stably acquire accurate radiation energy and an accurate radiation spectrum. In Embodiment 3, it is possible to acquire an accurate radiation spectrum without using the temperature adjustment unit. By not using the temperature adjustment unit, it is possible to reduce the size of the radiation detector 2, and the cost of the radiation detection apparatus 10 is reduced. Note that the signal processing unit 3 may be configured such that some or all of functions other than the information processing unit 34 are realized by software.

<Embodiment 4>

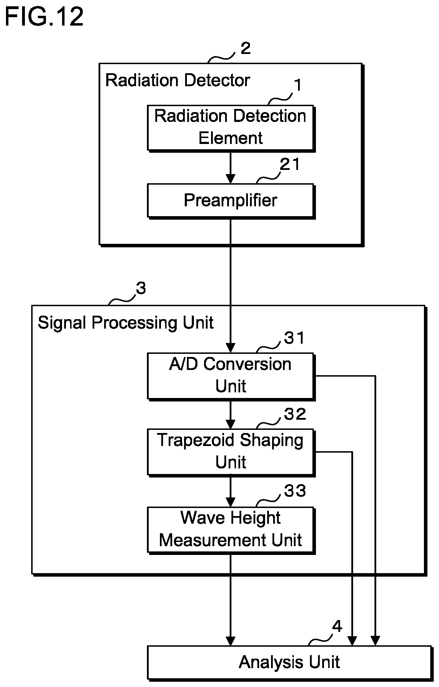

Embodiment 4 illustrates a configuration in which counting of radiation is performed by an analysis unit 4. A configuration of a part of a radiation detection apparatus 10 other than a signal processing unit 3 is the same as that of Embodiments 1 to 3. FIG. 12 is a block diagram illustrating a functional configuration of the radiation detector 2 and the signal processing unit 3 according to Embodiment 4. The radiation detector 2 is the same as that of Embodiment 1 or 2. An A/D conversion unit 31, a trapezoid shaping unit 32, and a wave height measurement unit 33 included in the signal processing unit 3 are the same as those of Embodiment 1 or 2. The signal processing unit 3 does not include an information processing unit or a counting unit. The signal processing unit 3 outputs a signal A/D converted by the A/D conversion unit 31 and a wave height measured by the wave height measurement unit 33. The analysis unit 4 receives input of the A/D converted signal and the wave height.

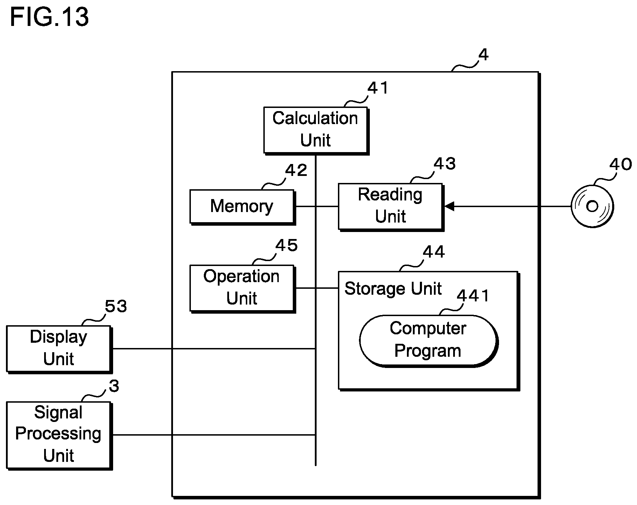

FIG. 13 is a block diagram illustrating an internal configuration example of the analysis unit 4. The analysis unit 4 is a computer such as a personal computer. The analysis unit 4 includes a calculation unit 41, a memory 42, a reading unit 43, a storage unit 44, and an operation unit 45. In addition, the analysis unit 4 is connected to a display unit 53 and the signal processing unit 3. The calculation unit 41 is configured using, for example, a CPU, a GPU, or a multi-core CPU. The calculation unit 41 may be configured using a quantum computer. The memory 42 stores temporary data generated in association with calculation. The memory 42 is, for example, a RAM (Random Access Memory). The reading unit 43 reads information from a recording medium 40 such as an optical disc or a portable memory.

The storage unit 44 is nonvolatile, and is, for example, a hard disk or a nonvolatile semiconductor memory. The operation unit 45 receives input of information such as text by receiving an operation from a user. The operation unit 45 is, for example, a touch panel, a keyboard, or a pointing device.

The calculation unit 41 causes the reading unit 43 to read a computer program 441 recorded on the recording medium 40, and causes the storage unit 44 to store the read computer program 441. The calculation unit 41 executes processing required for the analysis unit 4 in accordance with the computer program 441. The computer program 441 may be a computer program product. Note that the computer program 441 may be downloaded from outside the analysis unit 4. Alternatively, the computer program 441 may be stored in advance in the storage unit 44. In these cases, the analysis unit 4 does not have to include the reading unit 43. The computer program 441 may be deployed on a single computer, or may be distributed at one site or across a plurality of sites and loaded to be executed on a plurality of computers interconnected by a communication network. The analysis unit 4 may include a plurality of computers.

In Embodiment 4, the signal processing unit 3 performs processing of S101 to S103, S201 to S203, or S303 to S303. When a step wave has not been detected, the signal processing unit 3 outputs information indicating that a step wave has not been detected and an A/D converted signal. When a step wave has been detected, the signal processing unit 3 performs processing of S109, S208, or S309, and outputs an A/D converted signal and a wave height. The analysis unit 4 receives input of the A/D converted signal and the information indicating that a step wave has not been detected or the wave height, and performs processing of S104 to S108 or S110 to S111, S204 to S207 or S209 to S210, or S304 to S308 or S310 to S311. The calculation unit 41, according to the computer program 441, executes processing of S104 to S108 or S110 to S111, S204 to S207 or S209 to S210, or S304 to S308 or S310 to S311 performed by the information processing unit 34 and the counting unit 35 in Embodiments 1 to 3. In this instance, the analysis unit 4 executes processing corresponding to the correction unit and the counting unit. The signal processing unit 3 and the analysis unit 4 repeatedly execute processing of S101 to S111, S201 to S210, or S301 to S311. The analysis unit 4 generates a spectrum of radiation detected by the radiation detector 2 based on the corrected wave height of the step wave and the counted number. The analysis unit 4 causes the display unit 53 to display the spectrum of radiation. The analysis unit 4 may be configured to perform a process of measuring the wave height of the step wave, or a process of detecting the step wave.

In Embodiment 4, similarly to Embodiments 1 to 3, energy of radiation corresponding to the wave height is accurately specified without being affected by the temperature, and an accurate radiation spectrum not affected by the temperature is obtained. When compared to technology of correcting the wave height using the temperature sensor, accurate radiation energy is obtained, and an accurate radiation spectrum is obtained. Similarly, correction errors are reduced, and it is possible to stably acquire accurate radiation energy and an accurate radiation spectrum. In Embodiment 4, it is possible to acquire an accurate radiation spectrum without using the temperature adjustment unit. By not using the temperature adjustment unit, it is possible to reduce the size of the radiation detector 2, and the cost of the radiation detection apparatus 10 is reduced. Note that the signal processing unit 3 may be configured such that some or all of functions other than functions of the information processing unit 34 are realized by software.

Embodiments 1 to 4 illustrate a configuration in which the step wave is used as the response wave. However, the radiation detection apparatus 10 may be configured to use other response waves. For example, the signal processing unit 3 may be configured to use a pulse-shaped response wave having a shape obtained by differentiating a step wave. For example, the response wave may have a shape in which a signal value instantaneously rises and gradually exponentially decreases, and the signal processing unit 3 may shape the response wave into a step shape by integrating the signal, and measure and correct the wave height. The signal processing unit 3 may be configured to measure the wave height of the response wave using a method other than a method using the trapezoid shaping unit 32.

Embodiments 1 to 4 illustrate a configuration in which radiation is radiated onto the sample 62 and radiation generated from the sample 62 is detected. However, the radiation detection apparatus 10 may be configured to detect radiation transmitted through the sample 62 or reflected by the sample 62. The radiation detection apparatus 10 may be configured to scan the sample 62 with radiation by changing a direction of the radiation. The radiation detection apparatus 10 may be configured to radiate a moving sample with radiation. The radiation detection apparatus 10 may be configured not to include the radiation unit 54, the sample stage 61, or the display unit 53.

Embodiments 1 to 4 illustrate a configuration in which the semiconductor included in the radiation detection element 1 is Si. However, the radiation detection element 1 may include a semiconductor other than Si. Embodiments 1 to 4 illustrate a configuration in which the semiconductor portion 11 is made of an n-type semiconductor and the counter electrode 13 is made of a p-type semiconductor. However, the radiation detection element 1 may be configured such that the semiconductor portion 11 is made of a p-type semiconductor and the counter electrode 13 is made of an n-type semiconductor. In this configuration, holes are collected as electric charges in the signal output electrode 12. Embodiments 1 to 4 illustrate a configuration in which the radiation detection element 1 is a silicon drift type radiation detection element. However, the radiation detection element 1 may be an element other than the silicon drift type radiation detection element as long as the radiation detection element 1 is an element made of a semiconductor. For this reason, the radiation detector 2 may be a radiation detector other than an SDD.

The invention is not limited to content of the above-described embodiments, and various modifications are possible within the scope of the claims. In other words, embodiments obtained by combining technical means appropriately modified within the scope of the claims are also included in the technical scope of the invention.

The items described in each embodiment can be combined with each other. In addition, the independent claims and dependent claims described in the claims can be combined with each other in any and all combinations regardless of the citation format. Furthermore, the claims use a format in which a claim cites two or more other claims (multi-claim format). However, the invention is not limited thereto. A multi-claim that cites at least one multi-claim (multi-multi claim) may be used.

Reference Signs List

| | |
|---|---|
| 10 | radiation detection apparatus |
| 1 | radiation detection element |
| 2 | radiation detector |
| 3 | signal processing unit (signal processing device) |
| 33 | wave height measurement unit |
| 34 | information processing unit |
| 343 | computer program |
| 35 | counting unit |
| 4 | analysis unit |
| 441 | computer program |

**Claims**

1. A signal processing method, **characterized by** comprising:

   calculating a slope of a non-response line, which is a part other than a step wave, included in a signal including the step wave generated in response to detection of radiation;
   measuring a wave height of the step wave; and
   correcting the wave height according to the slope.

2. The signal processing method according to claim 1, **characterized by** further comprising:

   calculating a center line of the non-response line by smoothing the non-response line including noise; and
   calculating a slope of the center line as the slope of the non-response line.

3. The signal processing method according to claim 1 or 2, **characterized by** further comprising:

   calculating an instantaneous slope of the non-response line at a time point when a signal value included in the non-response line is obtained; and
   calculating a moving average of the instantaneous slope as the slope of the non-response line.

4. A signal processing method, **characterized by** comprising:

   calculating a noise level included in a signal including a step wave generated in response to detection of radiation;
   measuring a wave height of the step wave; and
   correcting the wave height according to the noise level.

5. The signal processing method according to claim 4, **characterized by** further comprising:

   using a first signal value, a second signal value, and a third signal value in a time series included in a non-response line, which is a part other than the step wave, included in the signal to calculate a difference value between a difference between the first signal value and the second signal value and a difference between the second signal value and the third signal value; and
   calculating a moving average of the difference value as the noise level.

6. The signal processing method according to claim 4, **characterized by** further comprising:

   smoothing a non-response line, which is a part other than the step wave, included in the signal to calculate a center line of the non-response line;
   calculating a square of a difference between the center line and a signal value included in the non-response line; and calculating a moving average of the square of the difference as the noise level.

7. A signal processing device, **characterized by** comprising:

a slope calculation unit configured to calculate a slope of a non-response line, which is a part other than a step wave, included in a signal including the step wave generated in response to detection of radiation; a wave height measurement unit configured to measure a wave height of the step wave; a correction unit configured to correct the wave height according to the slope; and a counting unit configured to count the step wave for each corrected wave height.

8. A signal processing device, **characterized by** comprising:

a noise calculation unit configured to calculate a noise level included in a signal including a step wave generated in response to detection of radiation; a wave height measurement unit configured to measure a wave height of the step wave; a correction unit configured to correct the wave height according to the noise level; and a counting unit configured to count the step wave for each corrected wave height.

9. A radiation detection apparatus, **characterized by** comprising:

a radiation detector configured to generate a step wave in response to incidence of radiation and output a signal including the step wave; a slope calculation unit configured to calculate a slope of a non-response line which is included in the signal and is a part other than the step wave; a wave height measurement unit configured to measure a wave height of the step wave; a correction unit configured to correct the wave height according to the slope; a counting unit configured to count the step wave for each corrected wave height; and a spectrum generation unit configured to generate a spectrum of the radiation based on a number counted by the counting unit.

10. A radiation detection apparatus, **characterized by** comprising:

a radiation detector configured to generate a step wave in response to incidence of radiation and output a signal including the step wave; a noise calculation unit configured to calculate a noise level included in the signal; a wave height measurement unit configured to measure a wave height of the step wave; a correction unit configured to correct the wave height according to the noise level; a counting unit configured to count the step wave for each corrected wave height; and a spectrum generation unit configured to generate a spectrum of the radiation based on a number counted by the counting unit.

11. A computer program, **characterized by** causing a computer to execute processing of:

calculating a slope of a non-response line, which is a part other than a step wave, included in a signal including the step wave generated in response to detection of radiation; and correcting a wave height of the step wave according to the slope.

12. A computer program, **characterized by** causing a computer to execute processing of:

calculating a noise level included in a signal including a step wave generated in response to detection of radiation; and correcting a wave height of the step wave according to the noise level.

FIG.1

FIG.2

FIG.3

FIG.4

FIG.5

FIG.6

# FIG.7

```
        ┌─────────────┐
        │    Start    │
        └──────┬──────┘
               │
        ┌──────┴──────┐
        │    Input    │ S101
        └──────┬──────┘
               │
        ┌──────┴──────┐
        │A/D conversion│ S102
        └──────┬──────┘
               │
              S103
          ╱─────────╲        YES
         ╱ A step wave╲──────────────┐
         ╲ detected?  ╱               │
          ╲─────────╱                 │
               │ NO                    │
               │                ┌──────┴──────┐
        ┌──────┴──────┐         │Measure the wave│ S109
        │Acquire a signal│ S104 │height of the step│
        │    value    │         │    wave     │
        └──────┬──────┘         └──────┬──────┘
               │                       │
        ┌──────┴──────┐         ┌──────┴──────┐
        │Calculate a center line of│ S105 │Correct the wave│ S110
        │a non-response line│      │height of the step│
        └──────┬──────┘         │    wave     │
               │                └──────┬──────┘
        ┌──────┴──────┐                │
        │Calculate an instantaneous│ S106 ┌──────┴──────┐
        │slope of the non-response line│  │  Counting   │ S111
        └──────┬──────┘                └──────┬──────┘
               │                              │
        ┌──────┴──────┐                       │
        │Calculate a moving average of│ S107  │
        │the instantaneous slope│             │
        └──────┬──────┘                       │
               │                              │
        ┌──────┴──────┐                       │
        │Store the slope of│ S108             │
        │the non-response line│               │
        └──────┬──────┘                       │
               │◄─────────────────────────────┘
        ┌──────┴──────┐
        │     End     │
        └─────────────┘
```

# FIG.8

# FIG.9

```
        ┌─────────────┐
        │    Start    │
        └─────────────┘
               │
        ┌─────────────┐
        │    Input    │ S201
        └─────────────┘
               │
        ┌─────────────┐
        │ A/D conversion │ S202
        └─────────────┘
               │
             S203
            ╱──────╲
          ╱  A step  ╲ YES
         ╱   wave      ╲──────────────────┐
         ╲  detected?  ╱                  │
          ╲          ╱                    │
            ╲──────╱                      │
             │ NO                         │
             │                  ┌──────────────────┐
             │                  │ Measure the wave │ S208
             │                  │ height of the step│
      ┌──────────────┐          │      wave         │
      │ Acquire a    │ S204     └──────────────────┘
      │ signal value │                    │
      └──────────────┘          ┌──────────────────┐
             │                  │ Correct the wave  │ S209
      ┌──────────────┐          │ height of the step│
      │ Calculate a  │ S205     │      wave         │
      │ difference   │          └──────────────────┘
      │ value between│                    │
      │ differences  │          ┌──────────────────┐
      └──────────────┘          │    Counting       │ S210
             │                  └──────────────────┘
      ┌──────────────┐                    │
      │ Calculate a  │ S206               │
      │ moving average│                   │
      │ of the       │                    │
      │ difference   │                    │
      │ value between│                    │
      │ the differences│                  │
      └──────────────┘                    │
             │                            │
      ┌──────────────┐                    │
      │ Store the    │ S207               │
      │ noise level  │                    │
      └──────────────┘                    │
             │◄───────────────────────────┘
        ┌─────────────┐
        │     End     │
        └─────────────┘
```

## FIG.10

```
                    ┌─────────────┐
                    │    Start    │
                    └──────┬──────┘
                           │
              ┌────────────────────────┐ S301
              │         Input          │
              └────────────┬───────────┘
                           │
              ┌────────────────────────┐ S302
              │     A/D conversion     │
              └────────────┬───────────┘
                           │
                      S303 │
                   ◇───────────────◇
                  / A step wave      \  YES ──────────────────┐
                  \   detected?      /                        │
                   ◇───────────────◇                          │
                           │ NO                                │
                           │                                   │
              ┌────────────────────────┐ S304    ┌────────────────────────┐ S309
              │  Acquire a signal value│         │    Measure the wave    │
              └────────────┬───────────┘         │ height of the step wave│
                           │                     └────────────┬───────────┘
              ┌────────────────────────┐ S305                 │
              │  Calculate a center    │         ┌────────────────────────┐ S310
              │  line of a             │         │ Correct the wave height│
              │  non-response line     │         │   of the step wave     │
              └────────────┬───────────┘         └────────────┬───────────┘
                           │                                  │
              ┌────────────────────────┐ S306    ┌────────────────────────┐ S311
              │ Calculate the square of│         │       Counting         │
              │ a difference between   │         └────────────┬───────────┘
              │ the signal value and   │                      │
              │ the center line        │                      │
              └────────────┬───────────┘                      │
                           │                                  │
              ┌────────────────────────┐ S307                 │
              │ Calculate a moving      │                     │
              │ average of the square   │                     │
              │ of the difference       │                     │
              └────────────┬───────────┘                      │
                           │                                  │
              ┌────────────────────────┐ S308                 │
              │   Store the noise level │                     │
              └────────────┬───────────┘                      │
                           │◄─────────────────────────────────┘
                    ┌──────────────┐
                    │     End      │
                    └──────────────┘
```

FIG.11

34

Information Processing Unit

341

Calculation Unit

342

Memory 343

Computer
Program

340

FIG.12

FIG.13

**EP 4 628 941 A1**

## INTERNATIONAL SEARCH REPORT

| | International application No. |
|---|---|
| | **PCT/JP2023/044958** |

| A. | CLASSIFICATION OF SUBJECT MATTER |
|---|---|

*G01T 1/17*(2006.01)i; *G01T 1/36*(2006.01)i
FI:   G01T1/17 H; G01T1/17 C; G01T1/36 D

According to International Patent Classification (IPC) or to both national classification and IPC

| B. | FIELDS SEARCHED |
|---|---|

Minimum documentation searched (classification system followed by classification symbols)

G01T1/00-1/16; 1/167-7/12

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2020-148688 A (HORIBA, LTD.) 17 September 2020 (2020-09-17) | 1-3, 7, 9, 11 |
| A | JP 2011-511927 A (PULSETOR, LLC) 14 April 2011 (2011-04-14) | 1-3, 7, 9, 11 |
| A | JP 10-282239 A (JEOL LTD.) 23 October 1998 (1998-10-23) | 1-3, 7, 9, 11 |
| A | US 2009/0034682 A1 (PULSETOR, LLC.) 05 February 2009 (2009-02-05) | 4-6, 8, 10, 12 |
| A | JP 10-282240 A (JEOL LTD.) 23 October 1998 (1998-10-23) | 4-6, 8, 10, 12 |
| A | US 2021/0318255 A1 (OLYMPUS SCIENTIFIC SOLUTIONS AMERICAS CORP.) 14 October 2021 (2021-10-14) | 1-12 |

☐ Further documents are listed in the continuation of Box C.          ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **13 February 2024** | **27 February 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

INTERNATIONAL SEARCH REPORT
Information on patent family members

International application No.

**PCT/JP2023/044958**

| Patent document cited in search report | | | Publication date (day/month/year) | Patent family member(s) | | | Publication date (day/month/year) |
|---|---|---|---|---|---|---|---|
| JP | 2020-148688 | A | 17 September 2020 | (Family: none) | | | |
| JP | 2011-511927 | A | 14 April 2011 | US | 2009/0033913 | A1 | |
| | | | | WO | 2009/020859 | A1 | |
| | | | | CN | 102160307 | A | |
| JP | 10-282239 | A | 23 October 1998 | (Family: none) | | | |
| US | 2009/0034682 | A1 | 05 February 2009 | WO | 2009/020866 | A1 | |
| JP | 10-282240 | A | 23 October 1998 | (Family: none) | | | |
| US | 2021/0318255 | A1 | 14 October 2021 | JP | 2023-521185 | A | |
| | | | | WO | 2021/207175 | A1 | |
| | | | | CN | 115443419 | A | |

Form PCT/ISA/210 (patent family annex) (July 2022)

**REFERENCES CITED IN THE DESCRIPTION**

**Patent documents cited in the description**

- JP 2015025740 A